# EUROPEAN PATENT APPLICATION

(11) **EP 4 550 426 A1**
(43) Date of publication of application: **07.05.2025**
(21) Application number: 24163308.0
(22) Date of filing: 13.03.2024
(51) Int. Cl.: H01L 31/0725, H01L 31/0216, H01L 31/05, H01L 31/075, H10K 30/57, H10K 30/82, H10K 39/15

(54) **SOLAR CELL AND PHOTOVOLTAIC MODULE**

(30) Priority: 31.10.2023 CN 202311442430
(71) Applicant: Zhejiang Jinko Solar Co., Ltd., Haining, Zhejiang 314416 (CN); JINKO SOLAR CO., LTD., Shangrao, Jiangxi 334100 (CN)
(72) Inventor: ZHANG, Yuanfang, Haining, Zhejiang (CN); XU, Menglei, Haining, Zhejiang (CN); YANG, Jie, Haining, Zhejiang (CN); ZHANG, Xinyu, Haining, Zhejiang (CN)
(74) Representative: Balder IP Law, S.L.

(57) **Abstract**

Embodiments of the disclosure relate to a solar cell and a photovoltaic module, where the solar cell includes a bottom cell, a recombination layer, and a top cell which are stacked in sequence in a first direction. The bottom cell includes a first semiconductor conductive layer, a substrate, and a second semiconductor conductive layer that are stacked in sequence in the first direction, and the second semiconductor conductive layer is disposed between the substrate and the top cell. The recombination layer is disposed between the second semiconductor conductive layer and the top cell and includes transparent conductive layers and at least one metal layer that are alternatingly stacked in the first direction, a top layer and a bottom layer of the recombination layer are both transparent conductive layers.

## Description

### TECHNICAL FIELD

The various embodiments described in this document relate in general to the technical field of solar cells, and specifically to a solar cell and a photovoltaic module.

### BACKGROUND

Fossil energy has air pollution and limited reserves, while solar energy has the advantages of cleanliness, no pollution, and abundant resources. Therefore, the solar energy is gradually becoming the core clean energy to replace fossil energy. Because of its good photoelectric conversion efficiency, solar cells have become the development focus of clean energy utilization.

In order to improve the efficiency of solar cells and the utilization rate of incident light as much as possible, the commonly used way is to laminate semiconductor cells with different band gaps to form tandem cells, so as to increase the energy utilization rate of sunlight and improve the photoelectric conversion efficiency of tandem cells as much as possible. However, there is a relatively large difference between the actual photoelectric conversion efficiency and the theoretical efficiency of the current tandem cells, and the structure of the tandem cell needs to be optimized and the photoelectric conversion efficiency needs to be improved.

### SUMMARY

Embodiments of the disclosure provide a solar cell and a photovoltaic module, which is at least beneficial to improving the photoelectric conversion efficiency of the solar cell.

Embodiments of the disclosure provide a solar cell. The solar cell includes a bottom cell, a recombination layer, and a top cell that are stacked in sequence in a first direction. The bottom cell includes a first semiconductor conductive layer, a substrate, and a second semiconductor conductive layer that are stacked in sequence in the first direction, and the second semiconductor conductive layer is disposed between the substrate and the top cell. The substrate is between the first semiconductor conductive layer and the second semiconductor conductive layer, and the bottom cell further includes first electrodes formed on a side of the first semiconductor conductive layer facing away from the substrate. The recombination layer is disposed between the second semiconductor conductive layer and the top cell and includes at least two transparent conductive layers and at least one metal layer that are alternatingly stacked in the first direction, a top layer and a bottom layer of the recombination layer are both transparent conductive layers, a respective transparent conductive layer has a first surface in contact with and at least partially covered by a respective metal layer.

In some embodiments, the recombination layer includes a first transparent conductive layer, the metal layer, and a second transparent conductive layer which are stacked sequentially in the first direction, where the first transparent conductive layer covers a surface of the second semiconductor conductive layer, and the second transparent conductive layer is in contact with the top cell.

In some embodiments, two first surfaces in contact with a same metal layer are in contact with each other in part of the two first surfaces not covered by the metal layer.

In some embodiments, a ratio of an area of an orthogonal projection of the respective metal layer on the first surface to an area of the first surface is in a range of 0.01 to 1.

In some embodiments, a ratio of a total thickness of the at least one metal layer to a thickness of the recombination layer is in a range of 0.05 to 0.5 in the first direction.

In some embodiments, the recombination layer has a thickness in a range of 2.5nm to 25nm in the first direction.

In some embodiments, the respective transparent conductive layer has a thickness in a range of 1nm to 20nm in the first direction.

In some embodiments, the respective metal layer has a thickness in a range of 0.1nm to 2nm in the first direction.

In some embodiments, the at least one metal layer has a light transmittance rate of greater than or equal to 95% for light with a wavelength of 550nm to 1200nm.

In some embodiments, conductivity of a material of the at least one metal layer is greater than or equal to conductivity of a material of the transparent conductive layers.

In some embodiments, a light transmittance rate of a material of the at least one metal layer is less than or equal to a light transmittance rate of a material of the transparent conductive layers.

In some embodiments, the material of the at least one metal layer includes copper, silver, molybdenum, or nickel.

In some embodiments, the recombination layer includes at least a first transparent conductive layer, a metal layer, and a second transparent conductive layer which are stacked sequentially in the first direction, where the first transparent conductive layer is closer to the bottom cell than the second transparent conductive layer, and refractive index of the first transparent conductive layer is greater than refractive index of the second transparent conductive layer.

In some embodiments, a refractive index of each of at least part of the transparent conductive layers has a decreased gradient in the first direction.

In some embodiments, each respective metal layer of at least part of the at least one metal layer includes at least one hollow portion running through the respective metal layer in the first direction, and the solar cell further includes at least one filling structure that fills the at least one hollow portion, and light transmittance of a material of the at least one filling structure is greater than or equal to light transmittance of a material of the respective metal layer.

In some embodiments, the respective metal layer includes at least two metal portions, and adjacent metal portions of the at least two metal portions are separated by a corresponding hollow portion.

In some embodiments, the at least two metal portions and the at least one hollow portion are alternatingly arranged in a second direction.

In some embodiments, the solar cell further includes second electrodes spaced apart from each other in a third direction, the second electrodes being disposed on a surface of the top cell facing away from the bottom cell in the first direction, an orthogonal projection of a respective second electrode on the respective metal layer is at least partially located in a corresponding metal portion.

In some embodiments, the second direction and the third direction are in a same direction or parallel to each other.

In some embodiments, the orthogonal projection of the respective second electrode on the respective metal layer is disposed in the corresponding metal portion.

In some embodiments, a ratio of an area of an orthogonal projection of the at least one hollow portion on the first surface to an area of an orthogonal projection of the at least two metal portions on the first surface ranges from 0.01 to 99.

In some embodiments, the bottom cell further includes: a tunneling layer disposed between the second semiconductor conductive layer and the substrate; and a passivation layer disposed on a surface of the first semiconductor conductive layer facing away from the substrate, where the first electrodes penetrate the passivation layer to be in ohmic contact with the first semiconductor conductive layer.

In some embodiments, the top cell includes a perovskite thin film solar cell, a copper indium gallium selenium thin film solar cell, a cadmium telluride thin film solar cell, an amorphous silicon thin film solar cell, or a Group III-V thin film solar cell.

In some embodiments, a photovoltaic module is provided. The photovoltaic module includes a plurality of cell strings, where each of the plurality of cell strings is formed by electrically connecting a plurality of solar cells described above, an encapsulation layer for covering surfaces of each of the plurality of cell strings, and at least one cover plate, wherein each cover plate is configured to cover a surface of the encapsulation layer facing away from the cell string.

### BRIEF DESCRIPTION OF THE DRAWINGS

One or more embodiments are illustrated by the figures in the corresponding drawings, which are not intended to be limiting to the embodiments, and the figures in the drawings are not to be limiting to scale unless specifically stated.
FIG. 1 is a schematic diagram of an overall structure of a solar cell according to embodiments of the present disclosure.
FIG. 2 is a schematic diagram of an overall structure of a solar cell according to other embodiments of the present disclosure.
FIG. 3 is a schematic structural diagram of a recombination layer according to embodiments of the present disclosure.
FIG. 4 is a schematic structural diagram of a recombination layer according to other embodiments of the present disclosure.
FIG. 5 is a structural schematic diagram of an orthogonal projection of a metal layer on a first surface according to embodiments of the present disclosure.
FIG. 6 is a schematic diagram of an overall structure of a solar cell according to other embodiments of the present disclosure.
FIG. 7 is a schematic diagram of an overall structure of a solar cell according to other embodiments of the present disclosure.
FIG. 8 is a top view of a metal layer according to embodiments of the present disclosure.
FIG. 9 is a top view of a metal layer according to other embodiments of the present disclosure.
FIG. 10 is a schematic diagram of an overall structure of a solar cell according to other embodiments of the present disclosure.
FIG. 11 is a schematic diagram of an overall structure of a solar cell according to embodiments of the present disclosure.
FIG. 12 is a structural schematic diagram of an orthogonal projection of a second electrode on the metal layer according to embodiments of the present disclosure.
FIG. 13 is a structural schematic diagram of an orthogonal projection of metal portions and second electrodes on a same first surface according to embodiments of the present disclosure.
FIG. 14 is a schematic diagram of an overall structure of a solar cell according to other embodiments of the present disclosure.
FIG. 15 is a structural schematic diagram of a photovoltaic module according to embodiments of the present disclosure.

### DETAILED DESCRIPTION OF THE EMBODIMENTS

In view of the above, the photoelectric conversion efficiency of current tandem cells needs to be improved.

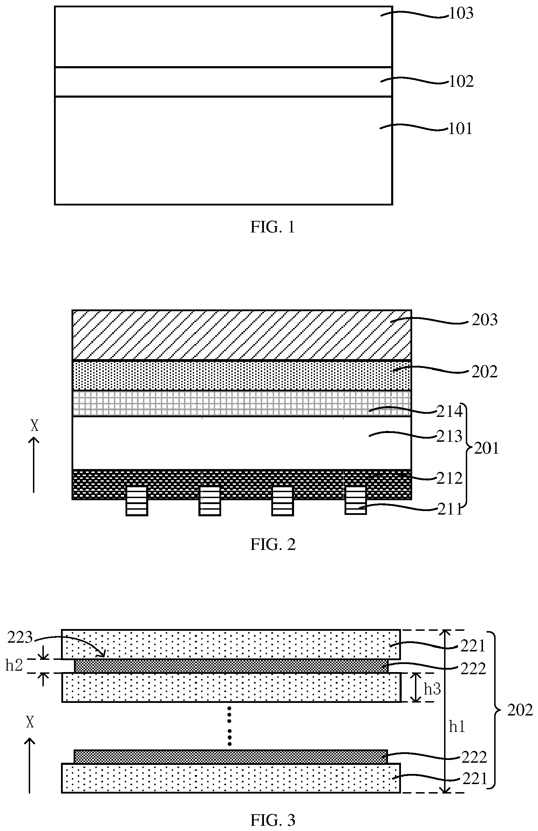

In some embodiments, referring to FIG. 1, a current tandem cell includes a bottom cell 101, an intermediate layer 102, and a top cell 103 that are stacked.

The tandem cell is generally formed as follows. The bottom cell 101 is provided, and the bottom cell 101 generally includes a first electrode layer, a first semiconductor conductive layer, a substrate, a second semiconductor conductive layer, and a second electrode layer which are stacked in order. After the bottom cell 101 is provided, the intermediate layer 102 may be formed directly on one surface of the bottom cell 101 in a direction in which all functional layers of the bottom cell 101 are stacked. The intermediate layer 102 may generally be provided by a transparent conductive film having a thickness. Thereafter, the top cell 103 is formed on a surface of the intermediate layer 102 away from the bottom cell 101, such that the bottom cell 101 and the top cell 103 are electrically connected through the intermediate layer 102.

The transparent conductive film may include a metal film, an oxide film, other compound films, a polymer film, a composite film, or the like. In order to balance conductivity and light transmittance, the transparent conductive film in the tandem cell is generally the oxide film, and a material of the transparent conductive film may include indium tin oxide, indium zirconium oxide, hydrogen doped indium oxide, or aluminum doped zinc oxide, or the like.

During forming of the tandem cell, a double-ended tandem cell is generally formed for convenience of use. The double-ended tandem cell means that electrodes on the side of the bottom cell 101 facing away from the top cell 103 serve as bottom electrodes of the tandem cell, and top electrodes of the tandem cell are formed on a side of the top cell 103 facing away from the bottom cell 101. The bottom cell 101 and the top cell 103 are connected in series by the intermediate layer 102, and carriers generated by the bottom cell 101 and the top cell 103 are output through the bottom electrodes and the top electrodes.

During forming of the double-ended tandem cell, a passivation layer and an electrode structure on a side of the bottom cell 101 are usually removed, and then the intermediate layer 102 is formed on the semiconductor conductive layer exposed on the bottom cell 101. The top cell 103 is formed on the side of the intermediate layer 102 facing away from the bottom cell 101. The bottom cell 101 and the top cell 103 being connected in series through the intermediate layer 102 may reduce parasitic light absorption in the tandem cell.

Embodiments of the disclosure provide a solar cell. After the electrode structure on the side of the bottom cell is removed, a recombination layer is used as the intermediate layer to electrically connect the top cell and the bottom cell. The recombination layer includes alternatingly stacked transparent conductive layers and metal layers, and a top layer and a bottom layer of the recombination layer are transparent conductive layers. The metal layers can effectively enhance the conductive performance of the recombination layer, and is beneficial to reduce the overall thickness of the recombination layer while maintaining the resistance characteristic unchanged, thereby reducing the parasitic light absorption caused by the recombination layer and improving the light absorption of the bottom cell. Under the condition of maintaining the same thickness, it is beneficial to reduce the overall resistance characteristics of the recombination layer, and then improve the carrier recombination efficiency of the recombination layer, so that the carriers generated by the top cell and the bottom cell can be fully recombined in the recombination layer, and the filling factor and photoelectric conversion efficiency of the tandem cell can be improved.

Embodiments of the present disclosure will be described in detail below with reference to the accompanying drawings. However, one of ordinary skill in the art will appreciate that in various embodiments of the present disclosure, numerous technical details have been presented in order to enable the reader to better understand the present disclosure. However, even without these technical details and various variations and modifications, based on the following embodiments, the technical solutions claimed in the present disclosure may be realized.

Embodiments of the present disclosure provide a solar cell. Referring to FIG. 2 and FIG. 3, FIG. 2 is a schematic diagram of an overall structure of a solar cell, and FIG. 3 is a schematic structural diagram of a recombination layer, where X direction in the figures is a first direction.

The solar cell includes a bottom cell 201, a recombination layer 202, and a top cell 203 which are stacked in the first direction. The bottom cell 201 includes a first semiconductor conductive layer 212, a substrate 213, and a second semiconductor conductive layer 214 that are stacked in the first direction, and the second semiconductor conductive layer 214 is disposed between the bottom cell 201 and the top cell 203. The substrate 213 is between the first semiconductor conductive layer 212 and the second semiconductor conductive layer 214, and the bottom cell 201 further includes first electrodes 211 formed on a side of the first semiconductor conductive layer 212 facing away from the substrate 213. The recombination layer 202 includes at least two transparent conductive layers 221 and metal layers 222 that are alternatingly stacked in the first direction, where the recombination layer 202 includes at least one metal layer 222, and top and bottom layers of the recombination layer 202 are both transparent conductive layers 221. A respective transparent conductive layer 221 has a first surface 223 in contact with and at least partially covered by a respective metal layer 222.

Since the recombination layer 202 includes the transparent conductive layers 221 and the metal layers 222 alternatingly stacked in the first direction, and both the top layer and the bottom layer of the recombination layer 202 are transparent conductive layers 221, when an electrode structure on a side of the bottom cell 201 facing the top cell 203 is removed, the bottom cell 201 directly contacts the recombination layer 202 through the second semiconductor conductive layer 214. The recombination layer 202 includes the at least one metal layer 222, the metal layer 222 effectively enhances the conductivity of the recombination layer 202. A thickness of the recombination layer 202 in the first direction can be reduced while maintaining the resistance characteristic of the recombination layer 202 unchanged, thereby reducing the parasitic light absorption of the recombination layer 202 to the light passing through the top cell 203, and increasing the light absorption amount of the bottom cell 201. Under the condition of keeping the thickness of the recombination layer 202 unchanged, the overall resistance of the recombination layer 202 can be effectively reduced, thereby improving the carrier recombination efficiency of the recombination layer 202, so that electrons generated by one of the top cells and the bottom cells and holes generated by the other of the top cells and the bottom cells can be fully recombined in the recombination layer, thereby improving the filling factor and photoelectric conversion efficiency of the solar cell.

During preparing of the solar cell, a bottom cell 201 having a complete cell structure can be provided, and then the electrode structure on the side of the bottom cell 201 can be removed by physical etching or chemical etching. If the side of the bottom cell 201 where the electrode structure is removed also has an antireflection layer for reducing light reflection, the antireflection layer of the bottom cell 201 is further etched, to expose the semiconductor conductive layer on the side of the bottom cell 201, and then the recombination layer 202 is formed on the exposed semiconductor conductive layer of the bottom cell 201. Thereafter, the top cell 203 is formed on the side of the recombination layer 202 facing away from the bottom cell 201. Alternatively, the process flow of the bottom cell 201 may be adjusted to merely form a semiconductor conductive layer on the side of the bottom cell 201, and then the recombination layer 202 and the top cell 203 may be prepared directly on the formed semiconductor conductive layer. Further, the recombination layer 202 may be formed as follows. Film layers in the recombination layer 202 may be formed layer by layer by a physical or chemical deposition process.

It shall be understood that FIG. 3 shows a cross-sectional view of a recombination layer 202, in the first direction, in which the metal layer 222 does not completely cover the first surface 223. In particular situations, the metal layer 222 may also completely cover the first surface 223 of the transparent conductive layer 221 in contact with the metal layer 222. That is, an edge of a surface where the metal layer 222 contacts the transparent conductive layer 221 is aligned with an edge of the first surface 223. The recombination layer 202 includes the at least one metal layer 222. For example, the recombination layer 202 may include two metal layers 222 and three transparent conductive layers 221, or include three metal layers 222 and four transparent conductive layers 221, or the like.

In addition, for a material and structure of the transparent conductive layer 221 in the recombination layer 202, reference may be made to the transparent conductive film as the intermediate layer 102 mentioned earlier, and thus the material and structure of the transparent conductive layer 221 will not be described herein.

In some embodiments, the bottom cell 201 may be a monocrystalline silicon cell, a polysilicon cell, an amorphous silicon cell, or a multicomponent compound cell or the like. The substrate 213 may be a P-type semiconductor substrate or an N-type semiconductor substrate. A doping type of one of the first semiconductor conductive layer 212 and the second semiconductor conductive layer 214 may be P-type, and a doping type of the other of the first semiconductor conductive layer 212 and the second semiconductor conductive layer 214 may be N-type. Doping concentration of a semiconductor conductive layer having the same doping type as the substrate 213 is greater than that of the substrate 213. The N-type semiconductor substrate is doped with an N-type doping element, and the N-type doping element can be any one of Group V elements, such as phosphorus (P), bismuth (Bi), antimony (Sb), or arsenic (As). The P-type semiconductor substrate is doped with a P-type doping element, and the P-type doping element can be any one of Group III elements, such as boron (B), aluminum (Al), gallium (Ga), or indium (In).

Further, the bottom cell 201 may be a monolithic cell or a slice cell, where the slice cell refers to a cell formed by cutting an entire monolithic cell through a cutting process.

In some embodiments, a material of the substrate 213 may be an elemental semiconductor material, the elemental semiconductor material includes a single element, such as, silicon or germanium. The elemental semiconductor material may be a monocrystalline state, a polycrystalline state, an amorphous state, or a microcrystalline state (i.e., a state having both a Monocrystalline state and an amorphous state). For example, silicon may be at least one of monocrystalline silicon, polycrystalline silicon, amorphous silicon, or microcrystalline silicon.

In some embodiments, the material of the substrate 213 may also be a compound semiconductor material. Common compound semiconductor materials include, but are not limited to, silicon germanium, silicon carbide, gallium arsenide, indium gallium, perovskite, cadmium telluride, copper indium selenium, and other materials. The substrate 213 may also be a sapphire substrate, a silicon-on-insulator substrate, or a germanium-on-insulator substrate.

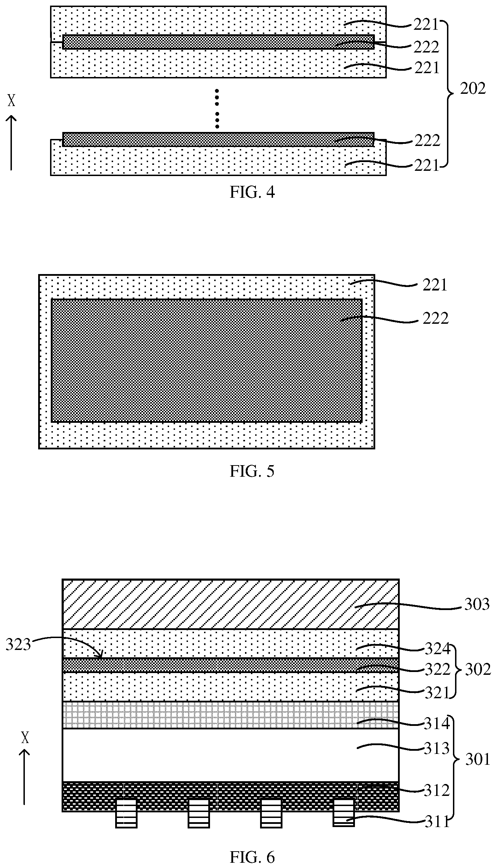

Referring in conjunction with FIGS. 2 to 4, in some embodiments, two first surfaces 223 in contact with a same metal layer 222 are in contact with each other in part of the two first surfaces not covered by the metal layer 222. FIG. 4 is a schematic structural diagram of a recombination layer 202.

The main function of the recombination layer 202 is to serve as an intermediate layer connecting the bottom cell 201 and the top cell 203, and thus, the conductivity of the recombination layer 202 may affect the photoelectric conversion efficiency of the solar cell. For two transparent conductive layers 221 in contact with the same metal layer 222, when the metal layer 222 covers a partial region of each of the two first surfaces 223 of the two transparent conductive layers 221 and the two transparent conductive layers 221 are not in contact with each other, it means that the two transparent conductive layers 221 are electrically connected with each other through the metal layer 222, such that carrier transport can merely be realized through the metal layer 222. In other words, for any of the two transparent conductive layers 221, carriers in the other regions of the transparent conductive layer 221 not covered by the metal layer 222 is unable to be transferred to the other transparent conductive layer 221, and carrier recombination between the top cell 203 and the bottom cell 201 is prone to large loss.

Therefore, in the case where the two first surfaces 223 in contact with the same metal layer 222 are not completely covered by the metal layer 222, the two adjacent transparent conductive layers 221 in contact with the same metal layer 222 can be arranged in a state of partial contact. That is, the two transparent conductive layers 221 in contact with the same metal layer 222 collectively define a closed cavity for receiving the metal layer 222, so that the regions of the two first surfaces 223 in contact with the same metal layer 222 that are not covered by the metal layer 222 are in contact with each other. Therefore, carrier interaction between the adjacent transparent conductive layers 221 can be realized through the metal layer 222 or the contact surfaces of the transparent conductive layers 221, thereby improving the carrier recombination efficiency between the adjacent transparent conductive layers 221 and further improving the conductivity of the recombination layer 202.

In addition, FIG. 4 describes that the metal layer 222 is a regular film layer, and the two first surfaces 223 partially covered by the same metal layer 222 have an equal area in regions covered by the metal layer 222 as an example for illustration. In specific situations, one first surface 223 of the two first surfaces 223 in contact with the same metal layer 222 may be completely covered by the metal layer 222, and the other first surface 223 of the two first surfaces 223 may not be completely covered by the metal layer 222. In this case, a filling layer may be provided on the first surface 223 which is not completely covered by the metal layer 222, so that the metal layer 222 forms, through the filling layer, an electrical connection with a part of the transparent conductive layer 221 not covered by the metal layer 222. The filling layer has a conductive capability and may include a material that is the same as the material of the transparent conductive layer 221 or the material of the metal layer 222. For example, an epitaxial portion of the transparent conductive layer 221 towards the metal layer 222 is formed through deposition process and the epitaxial portion is used as the filling layer.

Referring in conjunction with FIGS. 2, 3, and 5, in some embodiments, a ratio of an area of an orthogonal projection of the respective metal layer 222 on the first surface 223 to an area of the first surface 223 is in a range of 0.01 to 1. FIG. 5 is a structural schematic diagram of an orthogonal projection of a metal layer 222 on the first surface 223.

In the case where the metal layer 222 is a regular film layer, the area of the orthogonal projection of the respective metal layer 222 on the first surface 223 can be regarded as an area of a part of the first surface 223 covered by the metal layer 222. Therefore, the ratio of the area of the orthogonal projection of the respective metal layer 222 on the first surface 223 to the area of the first surface 223 can be regarded as a coverage rate of the metal layer 222 on the first surface 223. When the recombination layer 202 is formed using the metal layers 222 and the transparent conductive layers 221 that are sequentially stacked in the first direction, the greater the coverage rate of the metal layer 222 on the first surface 223, the more obvious the improvement of the conductivity of the recombination layer 202 by the metal layer 222.

Therefore, during forming of the recombination layer 202, the ratio of the area of the orthogonal projection of the respective metal layer 222 on the first surface 223 to the area of the first surface 223 may be set in the range of 0.01 to 1, for example, 0.015, 0.02, 0.03, 0.05, 0.075, 0.1, 0.125, 0.15, 0.2, 0.25, 0.35, 0.45, 0.6, 0.75, 0.85, or 0.95, or the like. By setting the coverage rate of the metal layer 222 on the first surface 223 within an appropriate range, the carrier recombination efficiency in the recombination layer 202 between the top cell 203 and the bottom cell 201 can be effectively improved, and the filling factor and photoelectric conversion efficiency of the solar cell can be improved.

In addition, a coverage rate of the metal layer 222 on one of the two first surfaces 223 in contact with the same metal layer 222 may be the same as or different from a coverage rate of the metal layer 222 on the other of the two first surfaces 223. In addition, in the case where the recombination layer 202 includes at least two metal layers 222, a coverage rate of a metal layer 222 on one of first surfaces 223 in contact with different metal layers 222 may be the same as or different from a coverage rate of the metal layer 222 on another of first surfaces 223, which is not limited in the embodiments of the present disclosure.

In addition, FIG. 5 shows a top view of the metal layer 222 in the first direction in the case that the metal layer 222 does not completely cover the first surface 223. In specific situations, the metal layer 222 may also be arranged to completely cover the first surface 223 in contact with the metal layer 222, that is, the ratio of the area of the orthogonal projection of the respective metal layer 222 on the first surface 223 to the area of the first surface 223 is 1.

Referring in conjunction with FIGS. 2 and 3, in some embodiments, the recombination layer 202 has a thickness ranging from 2.5nm to 25nm in the first direction.

The thickness of the recombination layer 202 in the first direction refers to a spacing h1 in the first direction between a surface of the recombination layer 202 in contact with the second semiconductor conductive layer 214 and a surface of the recombination layer 202 in contact with the top cell 203. The main function of the recombination layer 202 is to connect the bottom cell 201 and the top cell 203, so that carrier transport can be realized between the bottom cell 201 and the top cell 203. The influence of the recombination layer 202 on the photoelectric conversion efficiency of the solar cell is mainly reflected as follows. First, the conductivity of the recombination layer 202 may affect the carrier recombination efficiency between the bottom cell 201 and the top cell 203, and further, the parasitic light absorption of the recombination layer 202 may affect the light absorption amount of the bottom cell 201.

When the transparent conductive film is used to connect the bottom cell 201 and the top cell 203, it is generally necessary to set the thickness of the transparent conductive film to be large, so that the transparent conductive film has a low resistance characteristic, thereby improving the carrier recombination efficiency between the bottom cell 201 and the top cell 203 and reducing the carrier recombination loss. However, the relatively thick transparent conductive film may cause a relatively large parasitic light absorption, which may further affect the light absorption amount of the bottom cell 201, thus limiting the overall photoelectric conversion efficiency of the solar cell.

When the recombination layer 202 is used to connect the bottom cell 201 and the top cell 203, since the recombination layer 202 includes the at least one metal layer 222, the at least one metal layer 222 can effectively improve the conductivity of the recombination layer 202, such that the thickness of the recombination layer 202 can be set to be smaller than that of the transparent conductive film on the premise that the recombination layer 202 is ensured to have the same resistance characteristics as the transparent conductive film, thereby reducing the parasitic light absorption of the recombination layer 202.

Therefore, the thickness of the recombination layer 202 in the first direction may be set to be in the range of 2.5nm to 25nm, for example, 3nm, 3.5nm, 4.5nm, 5.5nm, 7.5nm, 10nm, 12.5nm, 16nm, 19nm, 23.5nm, etc. By setting the thickness of the recombination layer 202 to be in an appropriate range, the recombination layer 202 has good conductivity and the intermediate layer connecting the bottom cell 201 and the top cell 203 is ensured to have small parasitic light absorption, thereby increasing the carrier recombination efficiency between the bottom cell 201 and the top cell 203, reducing the carrier recombination loss, and increasing the light absorption amount of the bottom cell 201, thereby improving the photoelectric conversion efficiency of the solar cell.

In some embodiments, a ratio of a total thicknesses of the at least one metal layer 222 to the thickness of the recombination layer 202 is in a range of 0.05 to 0.5 in the first direction.

For any metal layer 222, a thickness of the metal layer 222 in the first direction refers to an average thickness of thicknesses of the at least one metal layer 222. For any metal layer 222, the thickness of the metal layer 222 refers to a distance h2 in the first direction between two surfaces of the metal layer 222 in contact with the two adjacent first surfaces 223. Referring to the above analysis and description of the metal layer 222, one of the main functions of the metal layer 222 is to enhance the conductivity of the recombination layer 202, thereby reducing the carrier recombination loss between the bottom cell 201 and the top cell 203. The reason for that the metal layer 222 can effectively reduce the resistance characteristics of the recombination layer 202 is that the metal layer 222 has stronger conductivity, and the recombination layer 202 can be regarded as a transparent conductive film with a part of the material replaced, and the replaced material has better conductivity. Therefore, in a case where the ratio of the sum of thicknesses of the at least one metal layer 222 in the first direction to the thickness of the recombination layer 202 in the first direction is sufficiently large, the resistance characteristics of the recombination layer 202 can be significantly improved.

Although the metal layer 222 has good electrical conductivity, the material of the metal layer 222 generally has less light transmittance than the material of the transparent conductive layer 221. When the ratio of the sum of the thicknesses of the at least one metal layer 222 in the first direction to the thickness of the recombination layer 202 in the first direction is too large, the light transmittance of the recombination layer 202 is greatly reduced due to the large proportion of the thicknesses of the at least one metal layer 222 with poor light transmittance, which may cause that the incident light received by the bottom cell 201 may be easily greatly reduced, thereby reducing the light absorption amount of the bottom cell 201, and resulting in a decrease in the photoelectric conversion efficiency of the bottom cell 201.

Therefore, during forming of the recombination layer 202, the ratio of the total thickness of the at least one metal layer 222 in the first direction to the thickness of the recombination layer 202 in the first direction may be set to be in the range of 0.05 to 0.5, for example, 0.075, 0.1, 0.125, 0.15, 0.2, 0.25, 0.325, 0.4, 0.45, etc. By setting the proportion of the sum of the thicknesses of the at least one metal layer 222 in the recombination layer 202 within an appropriate range, the metal layer 222 can effectively improve the conductivity of the recombination layer 202, and excessive decrease in the light transmittance of the recombination layer 202 caused by the metal layer 222 can be avoided, such that the carrier recombination loss between the bottom cell 201 and the top cell 203 can be reduced, and the influence of the recombination layer 202 on the light absorption amount of the bottom cell 201 can be reduced, thereby ensuring that the bottom cell 201 and the solar cell have good photoelectric conversion efficiency.

In some embodiments, the respective transparent conductive layer 221 has a thickness in the range of 1nm to 20nm in the first direction.

The thickness of the transparent conductive layer 221 in the first direction refers to an average thickness of thicknesses of the transparent conductive layers 221. For any transparent conductive layer 221, the thickness of the transparent conductive layer 221 refers to a distance h3 between two opposite surfaces of the transparent conductive layer 221 in the first direction. The main function of the transparent conductive layer 221 is to enable holes generated by one of the bottom cell 201 and the top cell 203 and electrons generated by the other of the bottom cell 201 and the top cell 203 to have a good recombination efficiency, so as to to realize the series connection of the bottom cell 201 and the top cell 203. The recombination efficiency of the holes and the electrons in the transparent conductive layer 221 is related to the conductivity of the transparent conductive layer 221. In the case of a same contact area, for each transparent conductive layer 221, the larger the thickness of the transparent conductive layer 221 in the first direction, the smaller the resistance characteristic of the transparent conductive layer 221 and the lower the carrier recombination loss.

In addition, the thickness of the transparent conductive layer 221 in the first direction also affects the light absorption of the transparent conductive layer 221. The larger the thickness of the transparent conductive layer 221, the greater the light absorption of the transparent conductive layer 221 to the light passing through the top cell 203. Therefore, if the thickness of the transparent conductive layer 221 is too large, the proportion of the light, received by the bottom cell 201, passing through the top cell 203 may obviously decrease, thereby causing the light absorption amount of the bottom cell 201 to be greatly reduced and limiting the photoelectric conversion efficiency of the bottom cell 201.

Therefore, during forming of the recombination layer 202, for any transparent conductive layer 221, the thickness of the transparent conductive layer 221 in the first direction may be set to be in the range of 1nm to 20nm, for example, 1.5nm, 2nm, 3nm, 4nm, 5.5nm, 7nm, 9nm, 11nm, 13.5nm, 16nm, 18.5nm, or the like. By setting the thickness of any of the transparent conductive layers 221 in an appropriate range, it is possible to enable that each of the transparent conductive layers 221 has good conductivity and enable limiting the light absorption capability of each of the transparent conductive layers 221 to a small range, such that light absorption of light rays passing through the top cell 203 by the recombination layer 202 can be reduced, and the light absorption amount of the bottom cell 201 and the overall photoelectric conversion efficiency of the solar cell can be improved.

In addition, during forming of the recombination layer 202, the plurality of transparent conductive layers 221 included in the recombination layer 202 may have a same thickness or different thicknesses in the first direction. During setting the specific thickness of the respective transparent conductive layer 221, the specific thickness of the respective transparent conductive layer 221 may be set to be in an appropriate range in combination with the number of layers of the transparent conductive layers 221 included in the recombination layer 202 and the thickness of the recombination layer 202 in the first direction, so as to avoid the thickness of the recombination layer 202 being too large or too small. For example, if the recombination layer 202 includes four transparent conductive layers 221 and three metal layers 222, the thickness of the recombination layer 202 in the first direction may be set to 21nm, the thickness of each transparent conductive layer 221 in the first direction may be set to 4.5nm, and the thickness of each metal layer 222 in the first direction may be set to 1nm. Alternatively, the thickness of each of two transparent conductive layers 221 in the first direction is set to 5nm, the thickness of each of the other two transparent conductive layers 221 in the first direction is set to 4nm, and the thickness of each metal layer 222 in the first direction is set to 1 nm.

In some embodiments, the respective metal layer 222 has a thickness h2 in a range of 0.1nm to 2nm in the first direction.

Referring to the above analysis and description of the metal layer 222, in order to ensure that the at least one metal layer 222 can effectively enhance the electrical conductivity of the recombination layer 202 and avoid a large decrease in the light transmittance of the recombination layer 202 caused by the arrangement of the at least one metal layer 222, the ratio of the sum of the thicknesses of the at least one metal layer 222 in the first direction to the thickness of the recombination layer 202 in the first direction can generally be set within a suitable range, for example, 0.05 to 0.5, 0.1 to 0.45, 0.15 to 0.3, or the like.

During forming of the metal layer 222, in addition to the ratio of the total thickness of the at least one metal layer 222 to the thickness of the recombination layer 202, the influence of the thickness of each metal layer 222 in the first direction on the properties of the metal layer 222 needs to be considered. The main function of the metal layer 222 is to enhance the conductivity of the recombination layer 202. For any metal layer 222, if the thickness of the metal layer 222 in the first direction is too small, the resistance characteristic of the metal layer 222 is relatively large, so that the conductivity of the recombination layer 202 may not be effectively improved. If the thickness of the metal layer 222 in the first direction is too large, the light transmittance of the metal layer 222 is greatly reduced, and the light absorption amount of the bottom cell 201 may be greatly reduced, thereby affecting the photoelectric conversion efficiency of the bottom cell 201.

Therefore, for any metal layer 222, the thickness of the metal layer 222 in the first direction may be set to be in the range of 0.1nm to 2nm, for example, 0.125nm, 0.15nm, 0.2nm, 0.25nm, 0.35nm, 0.5nm, 0.75nm, 1nm, 1.25nm, 1.5nm, 1.8nm, etc. By setting the thickness of the respective metal layer 222 in the first direction to be in the appropriate range, the at least one metal layer 222 can effectively enhance the conductivity of the recombination layer 202, and the light transmittance loss of the recombination layer 202 can be controlled to be within a small range, such that the light absorption loss of the bottom cell 201 can be reduced, thereby enhancing the carrier recombination efficiency between the bottom cell 201 and the top cell 203 while ensuring the photoelectric conversion efficiency of the bottom cell 201, reducing the carrier recombination loss between the bottom cell 201 and the top cell 203, and improving the filling factor and the photoelectric conversion efficiency of the solar cell.

In some embodiments, the at least one metal layer 222 has a light transmittance rate of greater than or equal to 95% for light with a wavelength of 550nm to 1200nm.

The light transmittance rate of the metal layer 222 is related to the thickness of the metal layer 222 in the first direction and a material of the metal layer 222. During disposing of any metal layer 222, a suitable material can be selected to form the metal layer 222, and the thickness of the metal layer 222 in the first direction can be set in an appropriate range, so that the metal layer 222 has good light transmittance.

In addition, the recombination layer 202 is provided between the top cell 203 and the bottom cell 201. Since the wavelength of light that can be absorbed by the top cell 203 is short and the wavelength of light that can be absorbed by the bottom cell 201 is long, the recombination layer 202 needs to have good light transmittance for light that has the long wavelength. Therefore, by adjusting the thickness and the material of the metal layer 222, the transmittance rate of the metal layer 222 to light having wavelengths in the range of 550nm to 1200nm can be set to be in the range of greater than or equal to 95%, for example, 95.5%, 96%, 97%, 98%, 99.5% or the like. The metal layer 222 is ensured to have a good transmittance for light passing through the top cell 203, thereby reducing the influence of the arrangement of the recombination layer 202 on the light absorption amount of the bottom cell 201 and ensuring the photoelectric conversion efficiency of the bottom cell 201.

In some embodiments, electrical conductivity of a material of the at least one metal layer 222 is larger than or equal to electrical conductivity of a material of the transparent conductive layer 221. One of the main functions of the metal layer 222 is to enhance the conductivity of the recombination layer 202. Therefore, during forming of the recombination layer 202, it is necessary to select a material of which conductivity is larger than or equal to that of the material of the transparent conductive layer 221 to form the metal layer 222, so that the conductivity of the formed metal layer 222 is larger than or equal to that of the transparent conductive layer 221, and further the conductivity of the recombination layer 202 is larger than or equal to that of a transparent conductive film having the same thickness as the intermediate layer, where the material of the transparent conductive film is the same as that of the transparent conductive layer 221.

In some embodiments, the light transmittance rate of the material of the metal layer 222 is less than or equal to a light transmittance rate of the material of the transparent conductive layer 221. Since the material of the transparent conductive layer 221 is generally the same as the material of the transparent conductive film mentioned above, the material of the transparent conductive layer 221 generally has good light transmittance. Since the main function of the metal layer 222 is to improve the conductivity of the recombination layer 202, in order to ensure that the metal layer 222 has good electrical conductivity, the material of the metal layer 222 is generally a material with good electrical conductivity, and the light transmittance of such metal materials is usually weaker than that of the transparent conductive layer 221. The light transmittance refers to the amount of light that can successfully pass through a film layer of a type of material with unit thickness. Therefore, in order to ensure the electrical conductivity of the metal layer 222, a specific type of metal material having electrical conductivity stronger than that of the transparent conductive layer 221 and light transmittance less than or equal to that of the transparent conductive layer 221 can be used to form the metal layer 222.

In some embodiments, the material of the metal layer 222 includes copper, silver, molybdenum, or nickel. The material of the metal layer 222 may be a single metal material having good electrical conductivity or include a plurality of metal materials having good electrical conductivity. During forming of the metal layer 222, one of copper, silver, molybdenum, and nickel may be used to form the metal layer 222. Alternatively, at least two of copper, silver, molybdenum, and nickel may also be selected to form the metal layer 222. Alternatively, the metal layer 222 may also be an oxide formed by at least one metallic material of copper, silver, molybdenum, and nickel, or an alloy formed by at least one metallic material of copper, silver, molybdenum, and nickel with other elements. There is no restriction on the specific material of the metal layer 222.

Referring to FIG. 6, in some embodiments, a recombination layer 302 includes a first transparent conductive layer 321, a metal layer 322, and a second transparent conductive layer 324 that are sequentially stacked in a first direction. The first transparent conductive layer 321 covers a surface of a second semiconductor conductive layer 314, and the second transparent conductive layer 324 is in contact with a top cell 303. FIG. 6 is a schematic diagram of an overall structure of a solar cell, and X direction is the first direction.

The bottom cell 301 and the top cell 303 are similar to the aforementioned bottom cell 201 and the top cell 203 respectively, and the recombination layer 302 is the scheme where the aforementioned recombination layer 202 contains only one metal layer 222. The first transparent conductive layer 321 and the second transparent conductive layer 324 are similar to the aforementioned transparent conductive layer 221. Both the first transparent conductive layer 321 and the second transparent conductive layer 324 contact the metal layer 322 through a respective first surface 323, and the first surface 323 is also similar to the aforementioned first surface 223, which is not be described here.

Referring to the above description and analysis of the recombination layer 202, the main function of the recombination layer 202 is to improve the carrier recombination efficiency between the bottom cell 201 and the top cell 203, reduce the carrier recombination loss between the bottom cell 201 and the top cell 203, and ensure that the bottom cell 201 has a sufficiently large light absorption amount, thereby significantly improving the filling factor and photoelectric conversion efficiency of the solar cell. Therefore, during forming of the recombination layer 302, the recombination layer 302 can be directly formed as a composite structure including the first transparent conductive layer 321 in contact with the second semiconductor conductive layer 314 of the bottom cell 301, the second transparent conductive layer 323 in contact with the top cell 303, and the metal layer 322 disposed between the first transparent conductive layer 321 and the second transparent conductive layer 324.

Since the recombination layer 302 includes two transparent conductive layers and the metal layer 322 between the transparent conductive layers, the metal layer 322 effectively improves the conductivity of the recombination layer 302, thereby significantly improving the carrier recombination efficiency and recombination rate of the carriers of the bottom cell 301 and the top cell 303 in the recombination layer 302, and reducing the carrier recombination loss between the bottom cell 301 and the top cell 303. In addition, the recombination layer 302 includes only one metal layer 322, and the arrangement of the metal layer 322 has little influence on the light transmittance and parasitic light absorption of the recombination layer 302. The proportion of light rays passing through the top cell 303 that can reach the bottom cell 301 is relatively high, and the bottom cell 301 has a large light absorption amount and a large photoelectric conversion efficiency.

In addition, FIG. 6 shows a cross-sectional view of the solar cell in the first direction in which the metal layer 322 completely covers the first surface 323 of the first transparent conductive layer 321 and the first surface 323 of the second transparent conductive layer 324. In the actual situations, the metal layer 322 may also cover only a partial region of the first surface 323. The two first surfaces 323 may be in contact with each other in part of the two first surfaces not covered by the metal layer 322, or the two first surfaces 323 are connected with the metal layer 322 through a filling medium, or the metal layer 322 is connected with one of the two first surface 323 through a filling medium. The filling medium may include a material same as a material of the first transparent conductive layer 321 or the second transparent conductive layer 324, or the filling medium may be served by an epitaxial portion of the first transparent conductive layer 321 and/or an epitaxial portion of the second transparent conductive layer 324.

Referring in conjunction with FIGS. 2 and 3, in some embodiments, in the first direction, refractive indices of the plurality of transparent conductive layers 221 gradually decrease when spacings between the plurality of transparent conductive layers 221 and the bottom cell 201 sequentially increase. For example, the recombination layer includes at least a first transparent conductive layer, a metal layer, and a second transparent conductive layer which are stacked sequentially in the first direction, where the first transparent conductive layer is closer to the bottom cell than the second transparent conductive layer, and refractive index of the first transparent conductive layer is greater than refractive index of the second transparent conductive layer.

Referring to the above description and analysis of the recombination layer 202, the arrangement of the recombination layer 202 may affect the light absorption of the bottom cell 201, thereby affecting the photoelectric conversion efficiency of the solar cell. When the light absorption rate is constant, the light absorption amount of the bottom cell 201 is mainly depended on the incident light intensity received by the bottom cell 201, and the influence of the recombination layer 202 on the incident light intensity received by the bottom cell 201 is mainly reflected in two aspects, one is the light absorption of the recombination layer 202 to the light passing through the top cell 203, and the other is the light reflection of the recombination layer 202 to the light passing through the top cell 203.

During the light passing through the recombination layer 202, when the refractive index of each transparent conductive layer 221 is equal or approximately equal, the transparent conductive layer 221 of the recombination layer 202 has a strong ability to reflect the incident light, thereby easily causing the recombination layer 202 to reflect a large part of the light that can be absorbed by the bottom cell 201 in a direction away from the bottom cell 201, and thus causing decrease of the light absorption amount of the bottom cell 201.

Based on the mechanism of light reflection and refraction, when the light passing through a medium of which refractive index is gradually increased, the reflection of the light may be greatly reduced. Therefore, during forming of the recombination layer 202, the plurality of transparent conductive layer 221 can be set to have different refractive indices, and in the first direction, the refractive indices of the plurality of transparent conductive layers 221 gradually decrease when the spacings between the plurality of transparent conductive layers 221 and the bottom cell 201 sequentially increase. Therefore, by enabling the refractive indices of the plurality of transparent conductive layers 221 in the recombination layer 202 to gradually decrease in the first direction, the reflection ability of the recombination layer 202 to light rays passing through the top cell 203 is greatly reduced, thereby reducing the reflection of the recombination layer 202 to light rays that can be absorbed by the bottom cell 201, increasing the light absorption amount of the bottom cell 201, and improving the photoelectric conversion efficiency of the bottom cell 201 and the solar cell.

It is to be understood that the refractive index of the transparent conductive layer 221 is represented by a specific refractive index of the transparent conductive layer 221, for example, an average refractive index, a minimum refractive index, or a maximum refractive index of the transparent conductive layer 221.

In embodiments of the present disclosure, the recombination layer 202 includes a plurality of transparent conductive layers 221. Referring to FIG. 6, during forming of the recombination layer 302, a refractive index of the first transparent conductive layer 321 may be set to A, and a refractive index of the second transparent conductive layer 324 may be set to B, where A is greater than B, thereby reducing the light reflection of the recombination layer 302 and increasing the proportion of incident light rays passing through the recombination layer 302 to reach the bottom cell 301.

In some embodiments, a refractive index of each of at least part of the plurality of transparent conductive layers 221 has a decreased gradient in the first direction.

In order to further reduce the influence of the recombination layer 202 on the light absorption amount of the bottom cell 201, the refractive index of each of the at least part of the plurality of transparent conductive layers 221 included in the recombination layer 202 may be set to have a decreased gradient in the first direction, thereby further reducing the reflection ability of the transparent conductive layer 221 to the light, and further reducing the light reflection ability of the recombination layer 202 as a whole.

For example, the recombination layer 202 includes three transparent conductive layers 221. A refractive index of a transparent conductive layer 221 at the middle of the three transparent conductive layers 221 (i.e., middle transparent conductive layer 221) may be set to have a decreased gradient in the first direction, or a refractive index of a transparent conductive layer 221 at the top of the three transparent conductive layers 221 (i.e., top transparent conductive layer 221 may be set to have a decreased gradient in the first direction, or a refractive index of each of the three transparent conductive layers 221 may be set to have a decreased gradient in the first direction. In addition, during forming of the recombination layer 202, the refractive index of each transparent conductive layer 221 may be set. In the first direction, a lower limit of the refractive index of the transparent conductive layer 221 at the bottom of the three transparent conductive layers 221 is greater than or equal to an upper limit of the refractive index of the middle transparent conductive layer 221, and a lower limit of the refractive index of the middle transparent conductive layer 221 is greater than or equal to an upper limit of the refractive index of the top transparent conductive layer 221.

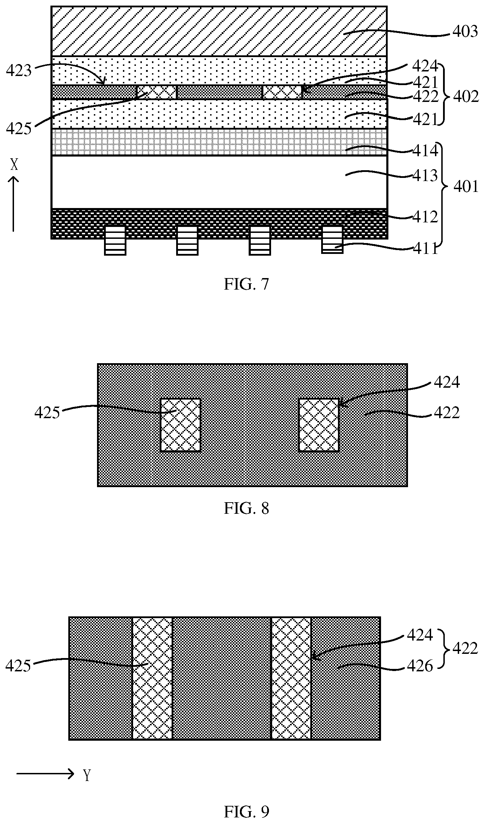

With reference to FIGS. 7 and 8, in some embodiments, the metal layer 422 includes at least one hollow portion 424 that runs through the metal layer 422 in the first direction X. The solar cell further includes at least one filling structure 425 that fills the at least one hollow portion 424. Light transmittance of a material of the at least one filling structure 425 is greater than or equal to light transmittance of a material of the metal layer 422. FIG. 7 is a schematic diagram of an overall structure of a solar cell, and FIG. 8 is a top view of the metal layer 422, where the X direction is a first direction.

The bottom cell 401 is similar to the aforementioned bottom cell 201 or bottom cell 301, the top cell 403 is similar to the aforementioned top cell 203 or top cell 303, the metal layer 422 is similar to the aforementioned metal layer 222 or metal layer 322, and the transparent conductive layer 421 is also similar to the aforementioned transparent conductive layer 221, which are not be described herein.

Since the arrangement of the metal layer 422 causes decrease of the light transmittance of the recombination layer 402, during the arrangement of the metal layer 422 and the recombination layer 402, at least one hollow portion 424 running through the respective metal layer 422 in the first direction can be defined in the metal layer 422, and then a respective filling structure 425 for filling a respective hollow portion 424 can be formed in the respective hollow portion 424, and the light transmittance of the material of the at least one filling structure 425 is greater than or equal to the light transmittance of the material of the metal layer 422.

A plurality of hollow portions 424 are defined on the metal layer 422, and the hollow portions 424 are filled with filling structures 425 having light transmittance greater than or equal to that of the metal layer 422. That is, an original part of the metal layer 422 is replaced with the filling structures 425 having stronger light transmittance, so that the light transmittance of the metal layer 422 can be improved, thereby improving the light transmittance of the recombination layer 402.

It is to be understood that a shape of an orthogonal projection of the respective hollow portion 424 on the first surface 423 may be a polygon such as a rectangle, a triangle, or a parallelogram, or may be a circle, an ellipse, and other shapes. The following describes the rectangle as an example of the shape of the orthogonal projection of the respective hollow portion 424 on the first surface 423, and the shape of the hollow portion 424 may be adjusted as required in specific situations.

In addition, the light transmittance of the material of the filling structure 425 is larger than or equal to the light transmittance of the material of the metal layer 422 and the filling structure 425 has certain electrical conductivity. For example, the material of the filling structure 425 may be the same as that of the transparent conductive layer 421, or the hollow portion 424 may be filled with the epitaxial portion of the transparent conductive layer 421 as the filling structure 425. That is, during the preparation of the recombination layer 402, the hollow portion 424 in the metal layer 422 may be filled with the transparent conductive layer 421 in contact with the metal layer 422, thereby ensuring light transmittance and reducing the difficulty and complexity of the process.

In addition, FIG. 7 shows a schematic diagram of the overall structure of the recombination layer 402 formed by laminating one metal layer 422 and two transparent conductive layers 421. The recombination layer 402 may also be a multi-layer structure including a plurality of transparent conductive layers 421 and at least two metal layers 422, and each of at least part of the metal layers 422 has a morphology with hollow portions 424. In FIG. 8, the metal layer 422 has two hollow portions 424. In actual situations, one metal layer 422 may have one or more hollow portions 424.

Referring in conjunction with FIGS. 7 and 9, in some embodiments, each metal layer 422 includes at least two metal portions 426, and adjacent metal portions 426 are spaced apart from each other by a corresponding hollow portion 424. FIG. 9 is another top view of the metal layer 422.

During forming of the metal layer 422, at least one hollow portion 424 may be defined to divide the metal layer 422 into at least two metal portions 426 spaced from each other, and adjacent metal portions 426 are separated by a corresponding hollow portion 424. For example, as shown in FIG. 9, the metal layer 422 may be divided into three metal portions 426 spaced from each other by the two hollow portions 424, so that an orthogonal projection of the hollow portions 424 on the first surface 423 has a larger area, thereby increasing a proportion of portions of the metal layer 422 replaced by the filling structure 425, effectively improving the light transmittance of the metal layer 422 and the recombination layer 402, and increasing the light absorption amount and photoelectric conversion efficiency of the bottom cell 401.

For ease of description and understanding, FIG. 9 is an illustration of the metal layer 422 including the three metal portions 426 and the two hollow portions 424. In actual situations, the metal layer 422 may include two metal portions 426 and at least one hollow portion 424, or include a plurality of metal portions 425 and a plurality of hollow portions 424.

In addition, the metal layer 422 shown in FIG. 9 includes the metal portions 426 and the hollow portions 424 alternatingly arranged in a direction. In actual situations, the metal layer 422 in which the metal portions 426 and the hollow portions 424 are randomly arranged may also be formed, which is not limited in the embodiments of the present disclosure.

Referring to FIG. 9, Y direction is a second direction. In some embodiments, the metal portions 426 and the hollow portions 424 are alternatingly arranged in a second direction.

During the arrangement of the metal layer 422, the metal portions 426 and the hollow portions 424 may be arranged alternatingly in a specific direction. For example, as shown in FIG. 9, the metal portions 426 and the hollow portions 424 are alternatingly arranged in the second direction. The metal layer 422 may be formed by selective deposition. For example, the plurality of metal portions 426 and the plurality of hollow portions 424 are sequentially formed. Alternatively, the entire metal layer 422 is selectively etched to form a plurality of hollow portions 424 and a plurality of metal portions 426 arranged alternatingly. Since the structure of the metal layer 422 is a regular structure in which the metal portions 426 and the hollow portions 424 are alternatingly arranged in the second direction, the difficulty of preparing the metal layer 422 through an industrial production process may be greatly reduced, and the light transmittance of the metal layer 422 may be improved, and the preparation efficiency and the overall quality of the metal layer 422 are facilitated.

Referring to FIG. 7, in some embodiments, a ratio of an area of an orthogonal projection of the at least one hollow portion 424 on the first surface 423 to an area of an orthogonal projection of the at least two metal portions 426 on the first surface 423 ranges from 0.01 to 99.

During forming of the metal layer 422, the main function of the metal layer 422 is to enhance the overall electrical conductivity of the recombination layer 402 by using the good electrical conductivity of the metal layer 422. The ratio of the area of the orthogonal projection of the at least one hollow portion 424 on the first surface 423 to the area of the orthogonal projection of the at least two metal portions 426 on the first surface 423 represents an area ratio of a non-good conductor portion to a good conductor portion of the metal layer 422.

When the ratio of the orthogonal projection area of the at least one hollow portion 424 to the orthogonal projection area of the at least two metal portions 426 is too small, the at least one hollow portion 424 accounts for a small proportion of the metal layer 422, the light transmittance of the metal layer 422 is not good, and the light absorption amount of the bottom cell 401 may be easily affected, thereby affecting the photoelectric conversion efficiency of the bottom cell 401 and the solar cell. When the ratio of the orthogonal projection area of the at least one hollow portion 424 to the orthogonal projection area of the at least two metal portions 426 is too large, the proportion of the at least one hollow portion 424 in the metal layer 422 is too large, and the proportion of the at least two metal portions 426 having good electrical conductivity is too small, so that the improvement of the electrical conductivity of the recombination layer 402 is limited.

Therefore, during forming of the metal layer 422, the ratio of the area of the orthogonal projection of the at least one hollow portion 424 on the first surface 423 to the area of the orthogonal projection of the at least two metal portions 426 on the first surface 423 ranges from 0.01 to 99, for example, 0.02, 0.05, 0.1, 0.25, 0.5, 1, 5, 10, 20, 35, 50, 75, 90, etc. In this way, the light transmittance of the metal layer 422 can be effectively increased, and the electrical conductivity of the recombination layer 402 is ensured to be effectively improved.

Further, in the case where the recombination layer 402 includes at least two metal layers 422, for each of the at least two metal layers 422, the ratio of the area of the orthogonal projection of the at least one hollow portion 424 of the metal layer 422 on the first surface 423 to the area of the orthogonal projection of the at least two metal portions 426 on the first surface 423 may be the same or different.

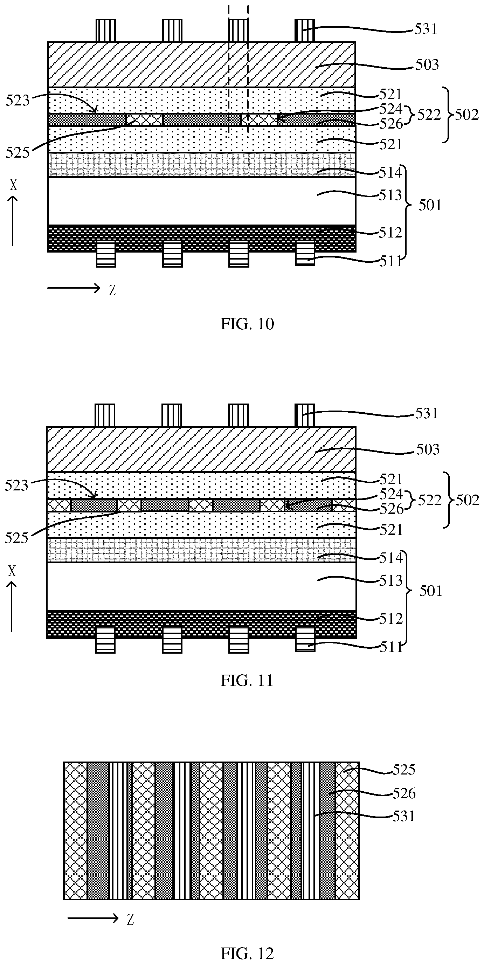

Referring to FIG. 10, in some embodiments, the solar cell further includes a plurality of second electrodes 531 spaced in a third direction, and the second electrodes 531 are disposed on a surface of the top cell 503 away from the bottom cell 501 in the first direction. An orthogonal projection of a respective second electrode 531 on the metal layer 522 is at least partially located a corresponding metal portion 526 in the metal layer 522. FIG. 10 is a schematic diagram of an overall structure of a solar cell, where X direction is a first direction and Z direction is the third direction.

The bottom cell 501, the top cell 503, and the recombination layer 502 in FIG. 10 are similar to the aforementioned bottom cell 401, the top cell 403, and the recombination layer 402, respectively. The plurality of second electrodes 531 may be provided on the surface of the top cell 503 facing away from the bottom cell 501, and the plurality of second electrodes 532 may be arranged at intervals in the third direction, to facilitate electric energy output. Referring to the above description and analysis of the recombination layer 402, the recombination layer 402 may easily affect the light absorption of the bottom cell 401, and the main reason for this problem is that the at least two metal portions 426 in the recombination layer 402 have poor light transmittance, and the at least two metal portions 426 may absorb and reflect a large part of the light incident on the at least two metal portions 426.

After the plurality of second electrodes 531 are provided, the plurality of second electrodes 531 may absorb and reflect a large part of the light incident on the plurality of second electrodes 531, and the light absorption of a part of the solar cell that directly faces the second electrodes 531 in the first direction is mainly affected by the interference of the second electrodes 531. The part of the respective second electrode 531 directly facing the respective metal portion 526 in the recombination layer 502 in the first direction on the light absorption of the bottom cell 501 may be greatly reduced.

Therefore, during forming of the solar cell, the second electrodes 531 may be arranged in the third direction based on positions of the metal portions 526, such that each of at least part of the metal portions 526 has a portion facing the respective second electrode 531 in the first direction. That is, an orthogonal projection of the respective second electrode 531 and an orthogonal projection of the respective metal portion 526 on the same first surface 523 are at least partially coincided with each other, or the orthogonal projection of the respective second electrode 531 on the metal layer 522 is at least partially located in the respective metal portion 526. Therefore, the influence of the at least part of the metal portions 526 on the light absorption of the bottom cell 501 is significantly reduced, thereby reducing the light absorption loss of the bottom cell 501 caused by the arrangement of the metal layer 522 and improving the photoelectric conversion efficiency of the bottom cell 501.

In some embodiments, the second direction and the third direction are in a same direction or parallel to each other.

During the arrangement of the metal layer 522, the direction in which the metal portions 526 and the hollow portions 524 are alternatingly arranged may be arranged parallel to or consistent with a direction in which the plurality of second electrodes 531 are arranged at intervals based on the design of the second electrodes 531 on the top cell 503. During arrangement of the metal layer 522, a lengthwise/length direction of the respective hollow portion 524 can be ensured to be consistent with a lengthwise direction of the second electrode 531, so that arrangement of the metal portions 526 in the metal layer 522 is similar to that of the second electrodes 531, which improves the aesthetics and facilitates controlling the proportion of the portion of the metal portion 526 facing the second electrode 531 in the metal portion 526 by moving horizontally along the arrangement direction. The length direction refers to an extension direction corresponding to the length.

In actual situations, the second direction and the third direction may be perpendicular to each other or may have an angle of less than 90 degrees therebetween, for example, an angle of 30 degrees, 45 degrees, 60 degrees, or the like, so as to ensure that each of the at least part of the metal portion 526 has the portion directly facing the respective second electrode 531.

Referring in conjunction with FIGS. 11 and 12, in some embodiments, an orthogonal projection of the respective second electrode 531 on the metal layer 522 is located within the respective metal portion 526. FIG. 11 is a schematic diagram of an overall structure of a solar cell, where X direction is the first direction. FIG. 12 is a structural schematic diagram of an orthogonal projection of a second electrode 531 on the metal layer 522.

In combination with the above description of the influence of the arrangement of the second electrodes 531 on the light absorption of the solar cell, the arrangement direction of the second electrodes 531 can be controlled to be consistent with the direction in which the metal portions 526 and the hollow portions 524 are alternatingly arranged in the metal layer 522, so that the metal portions 526 has an arrangement similar to that of the second electrodes 531. In order to further reduce the influence of the metal portions 526 on the light absorption amount of the bottom cell 501, the respective metal portion 526 may be aligned as much as possible with the respective second electrode 531, so that the proportion of the portion of the metal portion 526 that is aligned with the second electrode 531 is as large as possible. That is, the orthogonal projection of the respective second electrode 531 on the first surface 523 is within the orthogonal projection of the respective metal portion 526 on the same first surface 523, or the orthogonal projection of the second electrode 531 on the metal layer 522 is completely within a portion where the metal portion 526 is located.

By aligning the metal portion 526 with the second electrode 531 as much as possible, the orthogonal projection of the second electrode 531 on the metal layer 522 is completely located in the metal portion 526, the proportion of the portion of the metal portion 526 that has a small light absorption effect on the bottom cell 501 may be greatly increased, the influence of the metal layer 522 on the light absorption amount of the bottom cell 501 may be reduced as much as possible, and the light absorption amount of the bottom cell 501 may be increased.

In addition, in FIG. 12, the second direction and the third direction are in the same direction, and the length direction of the metal portion 526 is consistent with the length direction of the second electrode 531 and perpendicular to the second direction and the third direction. In specific situations, the length direction of the respective metal portion 526 and/or the arrangement direction of the metal portions 526 can be adjusted, to ensure that the orthogonal projection of the respective second electrode 531 on the metal layer 522 is completely located in the respective metal portion 526.

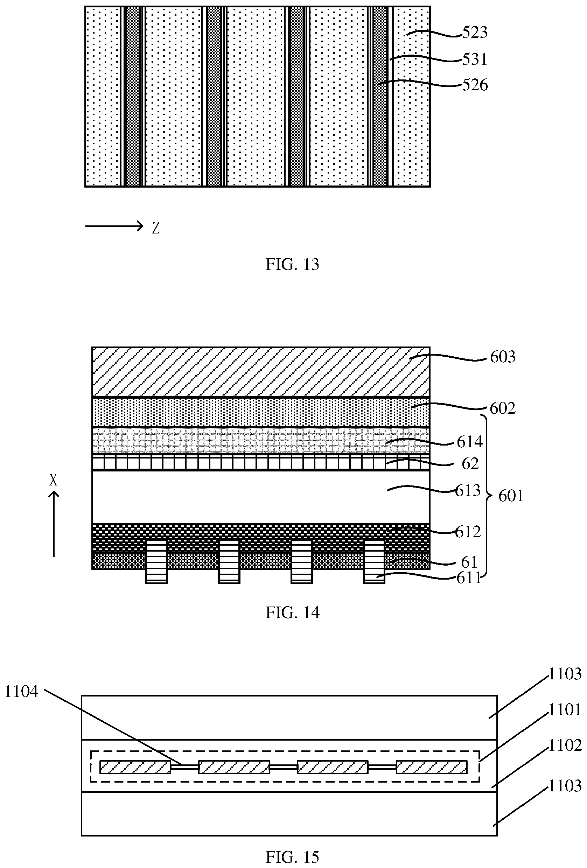

In addition, with reference to FIG. 12 and FIG. 13, FIG. 13 is a structural schematic diagram of an orthogonal projection of metal portions 526 and second electrodes 531 on a same first surface 523. During formation of the metal layer 522, at least one of the second direction, the length direction of the respective metal portion 526, and a width direction of the respective metal portion 526 can also be adjusted, so that the orthogonal projection of the respective metal portion 526 on the first surface 523 is completely within the orthogonal projection of the respective second electrode 531 on the same first surface 523. For example, the second direction and the third direction are parallel to each other, the length direction of the metal portion 526 is consistent with the length direction of the second electrode 531, and a width of the metal portion 526 in the second direction is equal to a width of the second electrode 531 in the third direction or the width of the metal portion 526 in the second direction is smaller than the width of the second electrode 531 in the third direction, so that the arrangement of the metal portions 526 in the metal layer 522 is consistent with the arrangement of the second electrodes 531, and each metal portion 526 is directly facing a corresponding second electrode 531 in the first direction.

In FIG. 13, the second direction and the third direction are in the same direction, and the width of the metal portion 526 in the second direction is smaller than the width of the second electrode 531 in the third direction. In specific situations, the width of the metal portion 526 in the second direction may be set to be equal to the width of the second electrode 531 in the third direction.

By adjusting the size, arrangement direction, length direction, and other parameters of the metal portions 526, the respective metal portion 526 of all the metal portions 526 is completely located directly below the respective second electrode 531 in the first direction, so that the light absorption of the solar cell may be mainly affected by the second electrodes 531, and the influence of the metal portions 526 and the metal layers 522 on the light absorption amount of the bottom cell 501 may be reduced as much as possible, thereby improving the photoelectric conversion efficiency of the bottom cell 501.

Referring to FIG. 7, in some embodiments, one transparent conductive layer, of the two transparent conductive layers 421 in contact with the same metal layer 422 in the first direction, having a smaller spacing with the bottom cell 401 has a first refractive index, the other transparent conductive layer 421, of the two transparent conductive layers 421, having a larger spacing with the bottom cell 401 has a second refractive index, and the at least one filling structure 425 that fills the at least one hollow portion 424 of the metal layer 422 has a refractive index greater than the second refractive index and less than the first refractive index.

Referring to the above description and analysis of the light reflection capability of the recombination layer 402, in the case where the refractive indices of the plurality of transparent conductive layers 421 are set to decrease gradually in the first direction, the recombination layer 402 can be regarded as a multilayer medium with a refractive index decreasing layer by layer in the first direction, and the light reflection capability of the recombination layer 402 is greatly decreased. For the two transparent conductive layers 421 that are in contact with the same metal layer 422, one of the two transparent conductive layer 421 that is less spaced from the bottom cell 401 can be regarded as having the first refractive index, and the other of the two transparent conductive layers 421 that is more spaced from the bottom cell 401 can be regarded as having the second refractive index, where the first refractive index is greater than the second refractive index.

When the at least one hollow portion 424 of the metal layer 422 is filled with the at least one filling structure 425, the refractive index of the at least one filling structure 425 is adjusted, so that the refractive index of the filling structure 425 can be larger than the second refractive index and smaller than the first refractive index. In addition, when the light rays are transmitted between the adjacent transparent conductive layers 421, the light rays passing through the at least one filling structure 425 is equivalent to that the light passes through an additional dielectric layer of which refractive index is in a range formed by the refractive indices of the two transparent conductive layers 421. That is, the light passes through a multilayer dielectric layer of which refractive index gradually increases in an incident direction of the light, which is beneficial to further reducing the light reflection of the recombination layer 402 to the light rays passing through the at least one filling structure 425, thereby improving the light absorption amount of the bottom cell 401.

In some embodiments, a refractive index of each of at least part of the at least one filling structure 425 has a decreased gradient in the first direction.

In order to further reduce the influence of the recombination layer 202 on the light absorption amount of the bottom cell 201, the refractive index of each of the at least part of the at least one filling structure 425 may also be set to have a decreased gradient in the first direction, thereby further reducing the light reflection ability of the filling structure 425 and further reducing the light reflection ability of the recombination layer 202 as a whole.

Referring to FIG. 14, in some embodiments, the bottom cell 601 further includes a passivation layer 61 and a tunneling layer 62. The tunneling layer 62 is disposed between the second semiconductor conductive layer 614 and the substrate 613, and the passivation layer 61 is disposed on a surface of the first semiconductor conductive layer 614 facing away from the substrate 613. First electrodes 611 of the bottom 601 are in ohmic contact with the first semiconductor conductive layer 612 after penetrating the passivation layer 61. FIG. 14 is a schematic diagram of an overall structure of a solar cell, where X direction is a first direction.

A complete passivation layer 61 is provided on the side of the bottom cell 601 facing away from the top cell 603, and the interface defect of the first semiconductor conductive layer 612 can be effectively improved by using the passivation layer 61, thereby reducing the carrier recombination of the bottom cell 601 on the surface of the first semiconductor conductive layer 612 and reducing the recombination current of the bottom cell 601, thereby effectively improving the photoelectric conversion efficiency of the bottom cell 601.

The bottom cell 601 includes the tunneling layer 62 between the second semiconductor conductive layer 614 and the substrate 613, the second semiconductor conductive layer 614 and the substrate 613 have a same doping type, and the second semiconductor conductive layer 614 and the tunneling layer 62 form a passivation contact structure, thereby providing good field passivation and interface passivation effects, effectively reducing the recombination current of the substrate 613 on the side of the second semiconductor conductive layer 614, increasing the open-circuit voltage of the bottom cell 601, and thus, improving the photoelectric conversion efficiency of the bottom cell 601.

In addition, in the embodiments of the present disclosure, the tunneling layer 62 being disposed between the second semiconductor conductive layer 614 and the substrate 613 and the second semiconductor conductive layer 614 and the substrate 613 having the same doping type are taken as an example for illustration. In actual situations, the tunneling layer 62 may also be disposed between the first semiconductor conductive layer 612 and the substrate 613, and the first semiconductor conductive layer 612 and the substrate 613 have the same doping type, which is not limited in the embodiments of the present disclosure.

In addition, in the embodiments of the present disclosure, the bottom cell 61 includes both the passivation layer 61 and the tunneling layer 62. In specific situations, the bottom cell 61 may also include only the passivation layer 61 or the tunneling layer 62.

In some embodiments, a material of the passivation layer 61 includes at least one of silicon oxide, aluminum oxide, silicon nitride, or silicon oxynitride, and the passivation layer 61 may be a single-layer structure or a stacked structure. For the stacked structure, a plurality of layers are sequentially stacked in the first direction, and materials of different layers may be different from each other, or materials of a partial number of layers may be the same and different from the materials of other layers. For example, the stacked structure may be a double-layer structure including a silicon nitride layer and an aluminum oxide layer that are stacked.

The top cell 603 and the recombination layer 602 in FIG. 14 are similar in configuration to those in the previous embodiment and will not be described here.

In some embodiments, the top cell 603 may include a perovskite thin film solar cell, a copper indium gallium selenium thin film solar cell, a cadmium telluride thin film solar cell, an amorphous silicon thin film solar cell, or a Group III-V thin film solar cell.

In order to improve the utilization rate of incident light by the solar cell, the top cell 603 and the bottom cell 601 may generally absorb light with different wavelengths based on band gaps of their own materials. The wavelength of light that the bottom cell 601 can efficiently utilize are generally in the range of 600nm to 1200nm. Therefore, a cell with a band gap of about 1.55ev can be selected as the top cell 603 to avoid the top cell 603 absorbing incident light with a wavelength greater than or equal to 800nm. The top cell 603 may therefore be any one of the perovskite thin film solar cell, the copper indium gallium selenium thin film solar cell, the cadmium telluride thin film solar cell, the amorphous silicon thin film solar cell, or the Group III-V thin film solar cell.

It is to be noted that the features in the above embodiments can not only exist in the solar cells alone, but also be implemented in combination with each other without technical conflicts and without exceeding the inventive concept of the embodiments of the present disclosure, and the embodiments of the present disclosure will not be described here.

Therefore, the embodiments of the disclosure provide the solar cell. After removing the electrode structure on one side of the bottom cell, the recombination layer is used as the intermediate layer to electrically connect the top cell and the bottom cell. The recombination layer includes alternatingly stacked transparent conductive layers and metal layers, and the top layer and the bottom layer of the recombination layer are transparent conductive layers. The metal layer can effectively enhance the conductive performance of the recombination layer. When the resistance characteristic is maintained unchanged, it is beneficial to reducing the overall thickness of the recombination layer, thereby reducing the parasitic light absorption brought by the recombination layer and improving the light absorption of the bottom cell. Under the condition of maintaining the same thickness, it is beneficial to reducing the overall resistance characteristics of the recombination layer, thereby improving the carrier recombination efficiency of the bottom cell and the top cell in the recombination layer, reducing the carrier recombination loss of the recombination layer, and improving the filling factor and photoelectric conversion efficiency of the solar cell.

Correspondingly, embodiments of the present disclosure further provide a photovoltaic module. Referring to FIG. 15, the photovoltaic module includes a plurality of cell strings 1101, each cell string 1101 being formed by electrically connecting a plurality of the above-mentioned solar cells, an encapsulation layer 1102 for covering surfaces of each of the cell strings 1101, and at least one cover plate 1103 each for covering a surface of the encapsulation layer 1102 facing away from the cell string 1101. The solar cells are electrically connected in a monolithic or a plurality of pieces to form the plurality of cell strings 1102, and the plurality of cell strings 1102 are electrically connected in series and/or in parallel.

In some embodiments, the plurality of cell strings 1102 may be electrically connected through conductive strips 1104. The encapsulation layer 1102 covers the front surface and the back surface of each solar cell. Specifically, the encapsulation layer 1102 may be an organic encapsulation film, such as, an ethylene-vinyl acetate copolymer (EVA) film, a polyethylene octene co-elastomer (POE) film, or a polyethylene terephthalate (PET) film. In some embodiments, the cover plate 1103 may be a glass cover plate, a plastic cover plate, or other cover plates having a light transmitting function. A surface of each cover plate 1103 facing the encapsulation layer 1102 may be a concave-convex surface, thereby increasing the utilization rate of incident light.

The terminology used in the description of the various described embodiments herein is for the purpose of describing particular embodiments only and is not intended to be limiting. As used in the description of the various described embodiments and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items. It will be further understood that the terms "includes," "including," "has," "having," "comprises," and/or "comprising," when used in this specification, specify the presence of stated features, integers, steps, operations, elements, and/or components, but do not preclude the presence or addition of one or more other features, integers, steps, operations, elements, components, and/or groups thereof.

In addition, when parts such as a layer, a film, a region, or a plate is referred to as being "on" another part, it may be "directly on" another part or may have another part present therebetween. In addition, when a part of a layer, film, region, plate, etc., is "directly on" another part, it means that no other part is positioned therebetween.

Although the present disclosure is disclosed as above with preferred embodiments, it is not intended to limit the claims. Any person skilled in the art may make certain possible changes and modifications without departing from the spirit and scope of the present disclosure. Therefore, the scope of protection of the present disclosure shall be subject to the scope defined in the claims of the present disclosure.

## Claims

1. A solar cell, comprising a bottom cell, a recombination layer, and a top cell that are stacked in sequence in a first direction, wherein
the bottom cell includes a first semiconductor conductive layer, a substrate, and a second semiconductor conductive layer that are stacked in sequence in the first direction, the second semiconductor conductive layer is disposed between the substrate and the top cell, the substrate is between the first semiconductor conductive layer and the second semiconductor conductive layer, and the bottom cell further includes first electrodes formed on a side of the first semiconductor conductive layer facing away from the substrate; and
the recombination layer is disposed between the second semiconductor conductive layer and the top cell, and includes at least two transparent conductive layers and at least one metal layer that are alternatingly stacked in the first direction, a top layer and a bottom layer of the recombination layer are both transparent conductive layers, a respective transparent conductive layer has a first surface in contact with and at least partially covered by a respective metal layer.

2. The solar cell of claim 1, wherein the recombination layer includes a first transparent conductive layer, the metal layer, and a second transparent conductive layer which are stacked sequentially in the first direction, wherein the first transparent conductive layer covers a surface of the second semiconductor conductive layer, and the second transparent conductive layer is in contact with the top cell; and
wherein two first surfaces in contact with a same metal layer are in contact with each other in part of the two first surfaces not covered by the metal layer.

3. The solar cell of claim 1 or 2, wherein a ratio of an area of an orthogonal projection of the respective metal layer on the first surface to an area of the first surface is in a range of 0.01 to 1.

4. The solar cell of any of claims 1 to 3, wherein a ratio of a total thickness of the at least one metal layer to a thickness of the recombination layer is in a range of 0.05 to 0.5 in the first direction.

5. The solar cell of any of claims 1 to 4, wherein the recombination layer has a thickness in a range of 2.5nm to 25nm in the first direction;
wherein the respective transparent conductive layer has a thickness in a range of 1nm to 20nm in the first direction; and
wherein the respective metal layer has a thickness in a range of 0.1nm to 2nm in the first direction.

6. The solar cell of any of claims 1 to 5, wherein the at least one metal layer has a light transmittance rate of greater than or equal to 95% for light with a wavelength of 550nm to 1200nm.

7. The solar cell of any of claims 1 to 6, wherein conductivity of a material of the at least one metal layer is greater than or equal to conductivity of a material of the transparent conductive layers and wherein a light transmittance rate of a material of the at least one metal layer is less than or equal to a light transmittance rate of a material of the transparent conductive layers.

8. The solar cell of claim 7, wherein the material of the at least one metal layer includes copper, silver, molybdenum, or nickel.

9. The solar cell of any of claims 1 to 8, wherein the recombination layer includes at least a first transparent conductive layer, a metal layer, and a second transparent conductive layer which are stacked sequentially in the first direction, wherein the first transparent conductive layer is closer to the bottom cell than the second transparent conductive layer, and refractive index of the first transparent conductive layer is greater than refractive index of the second transparent conductive layer;
optionally, wherein a refractive index of each of at least part of the transparent conductive layers has a decreased gradient in the first direction.

10. The solar cell of any of claims 1 to 9, wherein each respective metal layer of at least part of the at least one metal layer includes at least one hollow portion running through the respective metal layer in the first direction; and
the solar cell further includes at least one filling structure that fills the at least one hollow portion, and light transmittance of a material of the at least one filling structure is greater than or equal to light transmittance of a material of the respective metal layer.

11. The solar cell of claim 10, wherein the respective metal layer includes at least two metal portions, and adjacent metal portions of the at least two metal portions are separated by a corresponding hollow portion; and
wherein the at least two metal portions and the at least one hollow portion are alternatingly arranged in a second direction.

12. The solar cell of claim 11, wherein the solar cell further includes second electrodes spaced apart from each other in a third direction, the second electrodes being disposed on a surface of the top cell facing away from the bottom cell in the first direction, an orthogonal projection of a respective second electrode on the respective metal layer is at least partially located in a corresponding metal portion; and
wherein the second direction and the third direction are in a same direction or parallel to each other;
optionally, wherein the orthogonal projection of the respective second electrode on the respective metal layer is disposed in the corresponding metal portion.

13. The solar cell of claim 12, wherein a ratio of an area of an orthogonal projection of the at least one hollow portion on the first surface to an area of an orthogonal projection of the at least two metal portions on the first surface ranges from 0.01 to 99.

14. The solar cell of any of claims 1 to 11, wherein the bottom cell further includes:
a tunneling layer disposed between the second semiconductor conductive layer and the substrate; and
a passivation layer disposed on a surface of the first semiconductor conductive layer facing away from the substrate, wherein the first electrodes penetrate the passivation layer to be in ohmic contact with the first semiconductor conductive layer.

15. A photovoltaic module, comprising:
a plurality of cell strings, wherein each of the plurality of cell strings is formed by electrically connecting a plurality of solar cells of any of claims 1 to 14;
an encapsulation layer for covering surfaces of each of the plurality of cell strings; and
at least one cover plate, wherein each cover plate is configured to cover a surface of the encapsulation layer facing away from the cell string.
